# EUROPEAN PATENT APPLICATION

(11) **EP 4 579 735 A1**
(43) Date of publication of application: **02.07.2025**
(21) Application number: 24220855.1
(22) Date of filing: 18.12.2024
(51) Int. Cl.: H01L 23/495, H01L 23/552, H01L 21/48

(54) **ELECTROMAGNETIC SHIELDING FOR LEADLESS SEMICONDUCTOR PACKAGE**

(30) Priority: 28.12.2023 US 202318399098
(71) Applicant: NXP USA, Inc., Austin, TX 78735 (US)
(72) Inventor: TANG, Jingbang, 5656AG Eindhoven (NL)
(74) Representative: Colaiuda, Antonella

(57) **Abstract**

Structures and methods for electromagnetic shielding of leadless semiconductor packages provide complete module-level electromagnetic shielding by combining plated shielding with proposed modified ground lead arrangement and ground pad grounding. A package including a leadframe, ground leads, and signal leads is stamped to form a "bump" in the ground leads around the perimeter of the package. After overmolding, the package is cut to expose the bumps; then, a full shielding enclosure is formed over the top of the package into contact with the exposed ground leads. Components of the leadframe that extend to the perimeter of the device, such as corner bars connecting to the center flag, can also be stamped and brought into contact with the shield. The ground leads may further be connected to a center flag of the leadframe for full-enclosure shielding. The signal leads remain electrically isolated from the leadframe and the shielding enclosure.

## Description

### TECHNICAL FIELD

The embodiments of the present disclosure relate to structures and methods for providing electromagnetic shielding of semiconductor packages and, more specifically, to systems and methods for manufacturing of quad flat no-lead (QFN) modules with electromagnetic shielding.

### BACKGROUND

Semiconductor devices are often found in a large spectrum of electronic products-from home monitoring devices like smoke detectors and alarms to automotive sensors, and so on. Many of these semiconductor devices may include sensitive systems and may be produced in high volumes to drive costs down. In example manufacturing processes, multiple semiconductor devices can be manufactured as a strip or a sheet and then "singulated" through cutting processes that separate each device from the others. The composite product of such processes, known as a "package," may comprise active and passive microelectronic components, integrated circuits, bonding wires, etc., mounted on a printed circuit board (PCB) or other substrate. The package itself electrically connects to other components in an electronic system. While some package designs provide for such connections using protruding wires or pins, the present disclosure pertains to "leadless" semiconductor packages, which have exposed conductive surfaces, called "pads" or as a misnomer "leads," that do not protrude from the package. For example, quad flat no-lead (QFN) designs have exposed pads on the bottom of the package at its edges; the package is mounted on corresponding exposed pads on a PCB or other substrate.

Semiconductor devices for certain applications, such as high-sensitivity sensing, can be susceptible to interference from electromagnetic (EM) radiation and thus require EM shielding. A common solution for existing devices is to provide plates, casings, wires, or a combination thereof, made of high conductivity materials such as copper, aluminium, conductive polymers, metallized fabrics, etc. Properly positioned, these materials absorb or reflect unwanted EM energy, preventing the energy from reaching the sensitive parts of the device. Some of the more effective current solutions are designed to protect specifically selected components given a specific layout on a PCB; the reproducibility of these solutions is very low and the cost is very high. Additionally, these solutions may only provide partial shielding. Testing of current automotive safety sensors shows a maximum shielding of about 30 decibels of EM noise.

### SUMMARY

This disclosure provides package designs, systems, and methods for manufacturing leadless semiconductor devices in which the microelectronic components of the package are completely shielded from external electromagnetic energy. Effective and complete module-level EM shielding is realized by combining metal plate or other electromagnetic shielding, disposed over and around the periphery of the microelectronics package, with an arrangement of ground leads at the edges of the microelectronics package, resulting in complete EM shielding of internal sensitive components. Before overmolding, the leadframe is stamped to produce a raised bump in stamped portions of the ground leads and parts of the leadframe; the bumps in the ground leads leave the ground leads positioned higher (i.e., nearer the top of the device), where they are connected to side portions of the EM shielding enclosure. In embodiments, after the leadframe and ground leads are stamped, the semiconductor package is overmolded. A first cut is made from the top of the molded layer at a location chosen so the first cut meets the bump in each of the ground leads, exposing conductive surfaces of the ground leads; however, the first cut does not extend through the layer of molding compound over the signal leads. Then, metal plating, metal (or other EM shielding material) deposition (e.g., sputtering, evaporation), or other shielding methods dispose a layer of EM shielding over the layer of molding compound, into the cavity left by the first cut and thus into contact with the exposed contact surfaces of the ground leads (and other stamped parts of the leadframe, such as corner ground bars), but not into contact with the signal leads. An additional connection of each ground lead to a center flag (or ground flag) portion of the leadframe further enhances the EM shielding enclosure.

The proposed approach provides a complete EM shielding for the module with significantly improved EM shielding performance. The shielding solution is especially important for high frequency and high-speed applications and highly EMI sensitive products.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.
FIG. 1A is a top perspective view of an example electromagnetic shielded leadless semiconductor package in accordance with this disclosure.
FIG. 1B is a cross-sectional top view of the semiconductor package of FIG. 1A taken along line 1B-1B of FIG. 1A.
FIG. 1C is a cross-sectional side view of a portion of the microelectronics package of FIG. 1A taken along line 1C-1C of FIG. 1B.
FIG. 1D is a cross-sectional side view of a portion of the microelectronics package of FIG. 1A taken along line 1D-1D of FIG. 1B.
FIG. 2A is a diagrammatic partial top view of a strip of intermediate semiconductor packages before the start of an example shielding process in accordance with this disclosure.
FIGS. 2B and 2C are partial cross-sectional side views, taken along lines 2B-2B and 2C-2C, respectively, of FIG. 2A, illustrating an example shielding and manufacturing process of electromagnetic shielded leadless semiconductor packages in accordance with this disclosure.
FIG. 3A is a diagrammatic top view of another example intermediate semiconductor package before the start of an example shielding process.
FIG. 3B is a top perspective view of another example electromagnetic shielded leadless semiconductor package in accordance with this disclosure, manufactured from the example intermediate semiconductor package of FIG. 3A.

### DETAILED DESCRIPTION

It will be readily understood that the embodiments as generally described herein and illustrated in the appended figures could be arranged and designed in a wide variety of different configurations. Thus, the following more detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

Embodiments of this disclosure may present in other specific forms without departing from its essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment.

For simplicity, the described features, advantages, and characteristics of the invention are described throughout this specification may be described as being implemented within an embedded device, semiconductor device or package, microelectronic device, etc., including one or more microprocessors, other processing units, programmable and/or non-programmable memory, and other integrated circuits as well as individual circuit components and other pieces of electronic equipment, but the present devices and methods may be implemented in other electronic devices for which the described package designs, systems, and methods of manufacture would be useful.

In the next generation of microelectronic semiconductor devices, and thereafter, it would be advantageous to fully shield EM-sensitive components, such as sensors, and reach a much higher level of EM noise attenuation. Put generally, the embodiments described herein provide for the production of leadless microelectronic semiconductor devices using package designs that fully shield the internal components of the semiconductor package from EM interference. Effective and complete module level EM shielding is realized by combining a plated shield with a modified leadframe and grounding arrangement for complete shielding. The present manufacturing processes may be performed on a leadframe or similar packaging, including a microelectronics die disposed on a "center flag" portion (also known as a "ground flag," "mounting paddle," or "die pad," i.e., the portion on which the microelectronics die, comprising integrated circuits of the package, is mounted) of the leadframe and sensitive integrated circuit components attached to the die and to one or more ground leads and/or signal leads. Some or all of the ground leads may also be in contact with the center flag to improve EM shielding as described herein. A metal stamping step forms a "bump" in the ground leads and in elements of the leadframe, such as one or more connection bars at the corners of the package. The package is overmolded and then a first cut is made into the package to expose one or more conductive contact surfaces of the bump on each ground lead. Then, a controlled EM shielding step disposes metal top and side plates over the molding compound layer of the package and into contact with the exposed conductive surface(s) of the ground lead to fully enclose the module in EM shielding. Another cutting step then singulates each shielded device from other shielded devices in a strip or sheet of devices, leaving the ground leads in electrical contact with the EM shielding. The proposed approach can provide complete EM shielding for a leadless module with significantly improved EM shielding performance. The full enclosure shielding solution is especially important for high frequency and high-speed applications and highly EM-sensitive products.

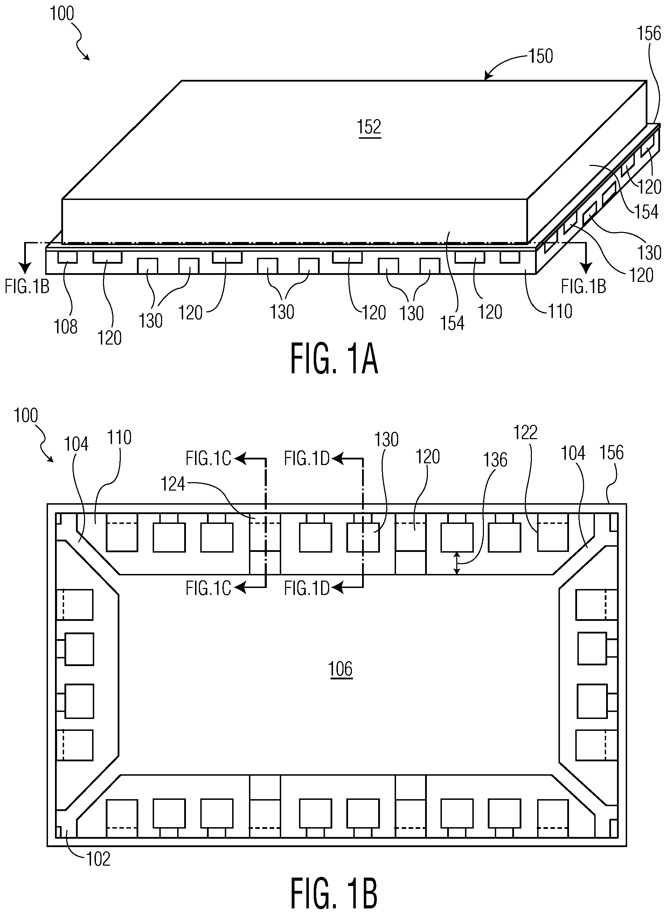

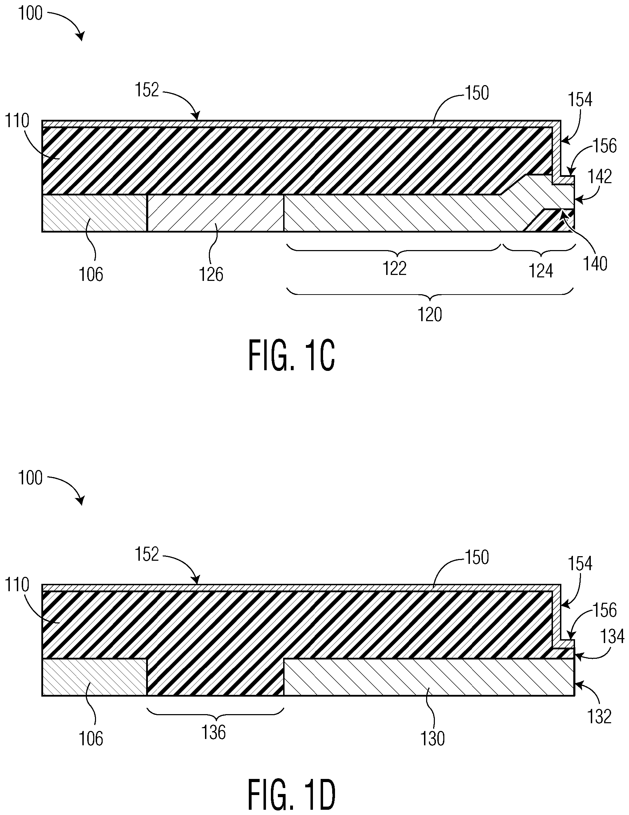

FIGS. 1A, 1B, 1C, and 1D illustrate an example microelectronic semiconductor device 100 manufactured to include full-enclosure EM shielding as described herein; the illustrations include the top perspective view of FIG. 1A illustrating the complete device 100, a simplified cross-sectional views of the device 100 from the top (FIG. 1B), and partial cross-sectional side views (FIGS. 1C and 1D) to illustrate electrical connectivity of a leadframe 102 of the device 100 with ground pads 122 and signal pads 130 of the device 100 and with a shielding enclosure 150 of the device 100. The device 100 includes a microelectronics package comprising the leadframe 102, one or more electronic components electrically connected to the leadframe 102, and a layer of molding compound 110 deposited, using any suitable overmolding or molding compound deposition technique, over the electronic components and onto/through the leadframe 102 to protect the components and the electrical connections. The leadframe 102 is a conductive metal layer that may serve as the base of a semiconductor device or may be deposited on a PCB or another substrate that serves as the base.

The leadframe 102 may be a metal sheet or film etched into segments to facilitate control of the signal paths between various components electrically connected to the leadframe 102. In embodiments, the leadframe 102 may comprise a plurality of connection bars 104 from the corners of the device into contact with a ground flag portion 106 that that provides a ground plane for the device 100 and also may serve as or support a die to (or upon) which electronic components are bonded. The device further includes a plurality of ground leads 120 each comprising the ground pads 122 of the device. The ground leads 120 further each comprise a stamped portion 124 extending from the ground pad 122 outward to a corresponding edge of the device 100. Additionally, some or all of the ground leads 120 may be electrically connected to the ground flag portion 106 by a connecting portion 126. In some embodiments, the connecting portion 126 may be part of the leadframe 102, e.g. by being integral with the ground flag portion 106. Alternatively, the connecting portion 126 may be mechanically attached to both the ground lead 120 and the ground flag portion 106; in various embodiments, the connecting portion 126 may be attached to the ground pad 122, to the ground flag portion 106, and/or to a PCB or other substrate on which the microelectronics package is mounted.

The device further includes a plurality of conductive lead pads 130 electrically isolated from the leadframe 102. In particular, where a ground lead 120 may be connected to the ground flag portion 106 by a connecting portion 126, a signal lead 130 is isolated from the ground flag portion 106 by a space 136 that may be approximately the same width as the connecting portion 126. The ground pads 122 and lead pads 130 may be exposed through the bottom and/or the edges of the device 100 to receive electrical connections of other devices to the device 100. In various embodiments, the ground lead 120 may have an exposed face 142 (see FIG. 1C) and the signal lead 130 may have an exposed face 132 (see FIG. 1D) that are each accessible from the corresponding edge of the device 100.

The electronic components that may be electrically connected to the leadframe 102 and to the signal pads 130 before the molding process include microcontrollers, sensors, wireless transmitters/receivers, application-specific and other integrated circuits, semiconductor devices, basic components such as capacitors and resistors, and the like. The components can be directly connected (e.g., via soldering), wire-bonded, etc., to bond the components in electrical contact with the leadframe 102 and/or the signal pads 130. Once the components are attached, an insulating, protective molding compound 110, which may be any suitable material used in semiconductor molding processes such as transfer, compression, or injection molding, flow deposition, etc., is deposited over the components and the leadframe 102 to produce a semiconductor package comprising the leadframe 102, ground leads 120, signal pads 130, all attached electronic components, and the molding compound 110.

The present disclosure provides an improved approach to EM shielding of a semiconductor package such as that of the device 100. The shielding enclosure 150 is designed to fully encapsulate the semiconductor package in EM shielding. The enclosure 150 comprises a top plate 152, a plurality of side plates 154 attached to or integral with the top plate 152 and with adjacent side plates 154, and a connecting portion 156 attached to or integral with the side plates 154 and electrically attached or connected to the leadframe 102 and the ground leads 120. Each of the top plate 152, side plates 154, and connecting portion 156 are made of a suitable metal for plated EM shielding, such as steel, copper, nickel, aluminum, and suitable alloys thereof; each of the top plate 102, the side plates 154, and the connecting portion 156 may be the same or different EM shielding materials (e.g., metals, conductive polymers). The enclosure 150 may be deposited or formed onto the semiconductor package using any suitable metal plating technique, provided a complete enclosure 150 is formed. For example, all of the top plate 152, side plates 154, and shoulder portion 156 may be formed in a single deposition process that creates all of the parts 152, 154, 156 of the enclosure 150 integrally with each other.

As shown in FIGS. 1C and 1D, the shielding enclosure 150 connects to the ground leads 120 at the stamped portion 124. The stamped portion 124 may include a contact portion 140 that, due to mechanical stamping, is disposed higher (i.e., elevated) within the device 100 relative to the ground pad 122. Through the manufacturing processes described below, this brings the contact portion 140 into contact with the shielding enclosure 150. For example, the side portion 154 terminating in a connecting portion 156 both contact the contact portion 140 of the ground leads 120 approximate the edges, and thus around the perimeter, of the device 100. On the other hand, the signal lead 130 is not raised and, as illustrated, does not contact the shielding enclosure 150. Rather, the signal lead 130 is separated and electrically insulated from the shielding enclosure 150 by an edge portion 134 of the molding compound 110; the signal lead 130 is thus prevented from connecting to ground.

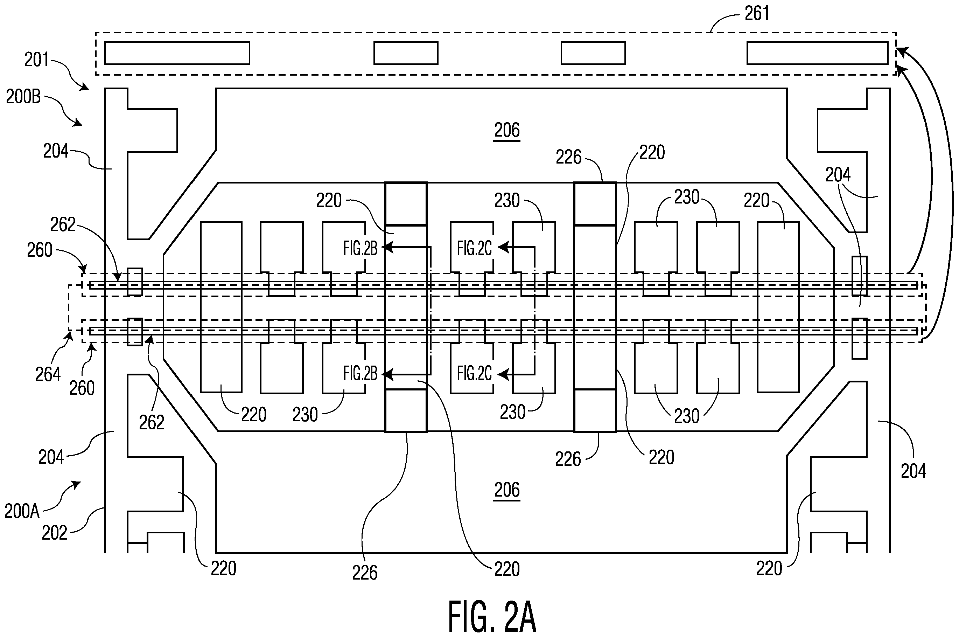

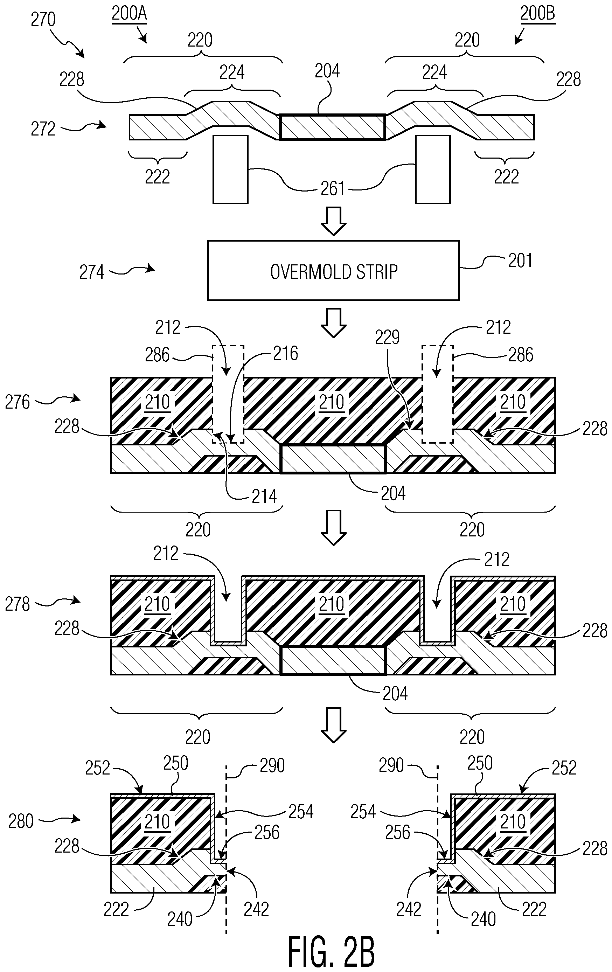

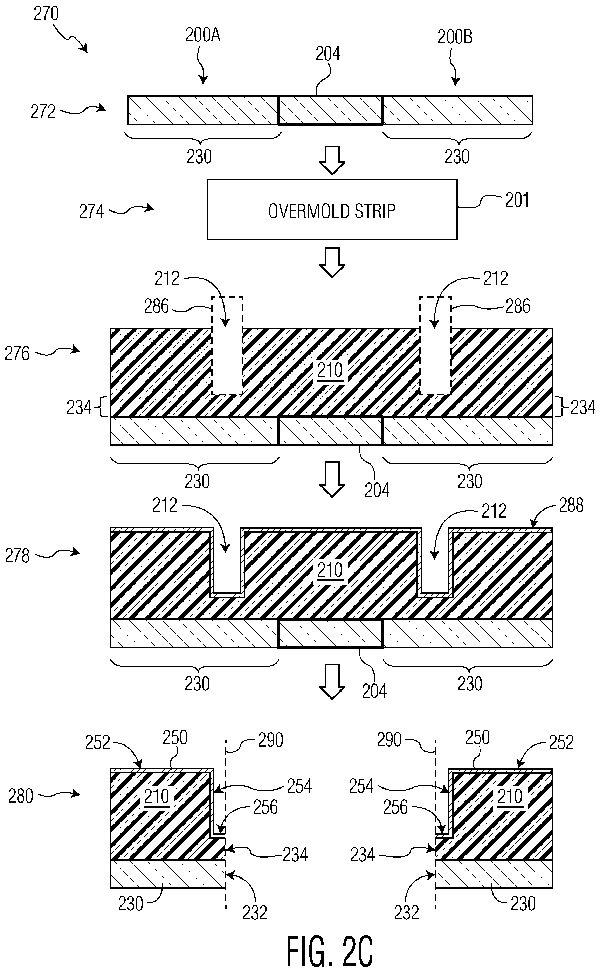

An example method of manufacturing a full-enclosure EM shielded leadless semiconductor device, such as the device 100 of FIGS. 1A-C, will now be described with reference to FIGS. 2A, 2B, and 2C. In FIG. 2A, example prefabricated semiconductor packages 200A, 200B are presented as conjoined in a strip 201 (or, a sheet) in advance of the first step of the example method. The conjoined packages 200A,B may share a leadframe 202 that includes a plurality of connection bars 204 (also known as tie bars) that serve to connect adjacent packages 200A,B to each other during certain phases of the manufacturing process. Each of the packages 200A,B may include a plurality of ground leads 220 and a plurality of signal leads 230 all attached to the connection bar 204 at the corresponding edge of the package 200A,B. Some or all of the ground leads 220 are also connected to a ground flag portion 206 of the leadframe 202 by a connecting portion 226 as described above.

FIG. 2A is further marked to indicate boundaries of the modifications to the packages 200A,B that occur during the present example method. A stamping boundary 260 indicates the approximate width of a mechanical stamp 261 to be applied, as well as the position abutting the connection bar 204 "below" (i.e., on package 200A) and "above" (i.e., on package 200B) where the stamp 261 will be applied. As shown, an example stamp 261 will mechanically contact only the ground leads 220 and portions of the leadframe 202, and will not contact the signal leads 230. A first cut boundary 262 indicates the approximate width and position on each package 200A,B where a cut into a layer of molding compound and into the ground leads, described below, will be performed. And, a second cut boundary 264 indicates the approximate width of a second cut that will singulate the packages 200A,B from each other after the shielding enclosure is applied and the manufacturing process is complete. It will be understood that the boundaries 260, 262, 264 are only shown on one of the connection bars 204 for clarity; the same stamping and cutting steps may be performed along all edges of the packages and across all connection bars 204 in the strip 201.

FIG. 2B and 2C illustrate the same steps of an example method 270 of manufacturing the present EM-shielded semiconductor devices; FIG. 2B shows the method 270 from the perspective of its modifications to adjacent ground leads 220 of the adjacent packages 200A,B, and FIG. 2C shows the method 270 from the perspective of adjacent signal leads 230. At 272, the packages 200A,B are stamped along the stamping boundaries 260 of FIG. 2A using the mechanical stamp 261. As shown in FIG. 2B, the stamp 261 raises a stamped portion 224 of the ground lead 220, disposed between the ground pad 222 and the connection bar 204; this leaves a "bump" 228 in the ground lead 220. As shown in FIG. 2C, however, the signal lead 230 is not contacted and thus not affected by the stamp. At 274, the packages 200A,B (i.e., of the strip 201 of FIG. 2A) may be overmolded, using any suitable microelectronics package overmolding technique to deposit one or more layers of molding compound 210 over the ground leads 220, signal leads 230, and connection bar(s) 204.

At 276, a cut 286 is made along the first cut boundaries 262 of FIG. 2A. The cut 286 may be made using any suitable mechanical or laser cutting method, and may extend substantially into the layer of molding compound 210, creating a void 212 that extends along the length of the cut 286. As shown in FIG. 2B, the cut 286 may extend partially or substantially into the bump 228 of each ground lead 220. The cut 286 thus exposes the ground lead 220, creating one or more contact surfaces of the ground lead 220 at and approximate the bottom of the void 212. For example, as illustrated, the cut 301 forms a notch in the ground lead 220, the notch defined by a vertical contact surface 214 corresponding to the outer vertical edge of the cut 286 and a horizontal contact surface 216 corresponding to the vertically deepest edge of the cut 286. By "partially or substantially," it is meant that the cut extends into the bump 228 of the ground lead 220 far enough to expose sufficient surface area ground lead 220 that the metal plating subsequently applied will form a substantial mechanical and chemical bond with the ground lead 220 at the exposed contact surface(s) 214, 216 when applied as described below. Both the horizontal and the vertical depths of the cut 286 into the ground lead 220 can be, for example, to a depth of between 5 micrometers to 15 micrometers into the ground lead 220, which may have a thickness of between 100 and 300 micrometers.

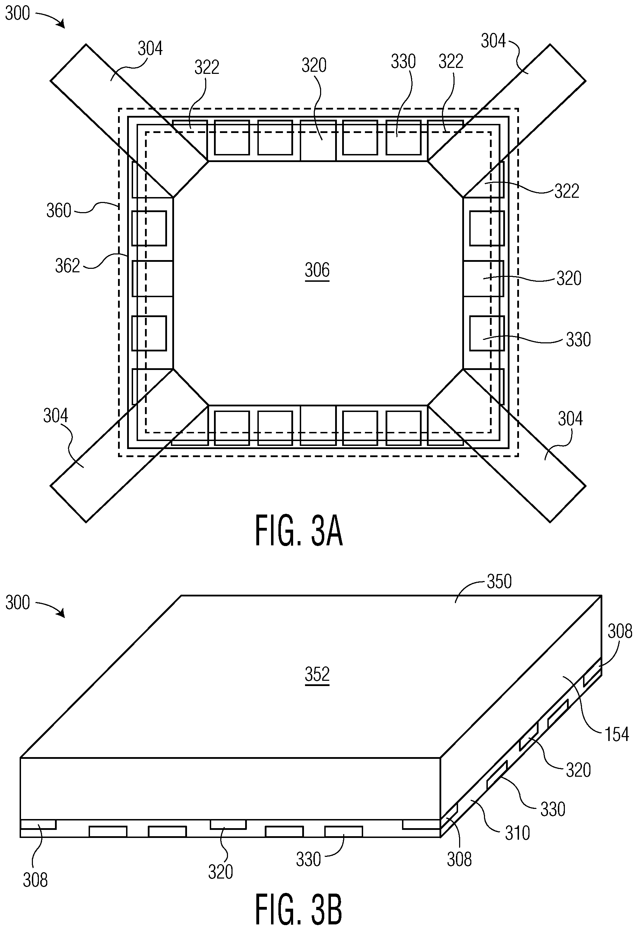

While not illustrated in FIG. 2B, it will be understood that the cut 286 will also expose contact surfaces of other elements of the leadframe that are stamped during step 272. This is further illustrated and described below with respect to FIGS. 3A and 3B. On the other hand, as shown in FIG. 2C, the step 276 of creating the cut 286 importantly does not expose the signal lead 230. The cavity 212 may extend substantially into the layer of molding compound 210, but leave a portion 234 of molding compound 210 below, which has sufficient thickness to electrically isolate the signal lead 230 from the EM shielding material deposited in the next step.

At 278, the packages 200A,B are electromagnetically shielded, by metal electroplating, metal material deposition or dispensing, or another suitable method for applying EM shielding material 288, such as a copper-nickel or copper-aluminum alloy, to the exposed surfaces of the packages 200A,B. The figures illustrate a single-layer deposition across the entirety of the strip 201, so that the layer of shield material 288 is deposited on the top surface of the layer of molding compound 210 and into the cavities 212, covering the sides and bottom of the cavity 212 formed by both molding compound 210 and by the exposed conductive surfaces 212, 214 of the ground lead 220. The shield material 288 hardens or cures to produce a shielding enclosure 250 of the semiconductor packages 200A,B; in particular, the parts of the shielding enclosure 250 in contact with the exposed conducting surface(s) of the ground leads 220 and the leadframe 202 bond to said surface(s), creating a permanent electrical and mechanical connection between the shielding enclosure 250, the ground leads 220, and the leadframe 202. At 280 the semiconductor packages 200A,B are singulated from the strip 201 with another cut 290 along the second cut boundary 280 of FIG. 2A. As shown, the cut 290 completely eliminates the materials between the respective cavities 212 of the formerly-adjoining packages 200A,B. This includes the corresponding connection bar 204; consequently, the cut 290 severs the electrical connection between the ground leads 220, which remain grounded to the leadframe 202 and connected to the shielding enclosure 250, and the signal leads 230, which are now electrically isolated from the leadframe 202 and shielding enclosure 250. The cut 290 serves to define the perimeter of the corresponding package 200A,B including an outer edge where the connecting portion 256 is flush with an exposed face 242 of a connecting portion 240 of the ground lead 220, and with an exposed face 232 of the signal lead 230.

Referring to FIGS. 3A and 3B, another example semiconductor device 300 is depicted in which corner bars 304 of a leadframe (not shown) extend from the corners of the device 300 footprint into contact with a ground flag portion 306 of the leadframe. The corner bars 304 may in turn connect to connection bars of the leadframe within a strip of devices as described above. The corner bars 304 may also be disposed in connection with corner ground pads 322 of the device 300, which may include ground pads 320 disposed along the edges of the device 300 and in contact with the ground flag portion 306 as described above. As in FIG. 2A, FIG. 3A provides a stamping boundary 360 and a first cut boundary 362 each around the entirety of the device 300. Again, the corresponding mechanical stamp (not shown) and first cut (not shown) will contact the edge ground pads 320, the corner ground pads 322, and the corner bars 304, but not any of the signal pads 330. A shielding enclosure 350 may then be deposited as described above, with side portions 154 contacting a top portion 352 and contacting the exposed contact surfaces of the "bumps" on the ground pads 320, 322 and corner bars 304. This may provide a corner connection 308 of the shielding enclosure 350 to the leadframe that, due to additional surface area, provides better shielding.

The present disclosure describes various implementations of a full-enclosure EM shielded microelectronic semiconductor device and methods of manufacture that completely shield sensitive components from EM noise. In some aspects, the disclosure provides a method of manufacturing a semiconductor device, the method including providing a microelectronics package including: a leadframe providing a ground plane for the microelectronics package; a plurality of ground leads in electrical communication with the leadframe, the plurality of ground leads extending to a perimeter of the microelectronics package; and, a plurality of signal leads extending to the perimeter of the microelectronics package. The method includes the steps of: stamping the microelectronics package to produce in each of the plurality of ground leads a stamped portion that is elevated relative to the plurality of signal leads; affixing one or more microelectronic components to one or both of the leadframe and one or more of the plurality of signal leads; disposing a layer of molding compound over the leadframe, the plurality of ground leads, the plurality of signal leads, and the one or more microelectronic components, the layer having a top surface extending over the microelectronics package; making a first cut extending from a top of the microelectronics package into the stamped portion of each of the plurality of ground leads to expose corresponding one or more contact surfaces of each of the plurality of ground leads; and, forming a shielding enclosure that completely covers the top surface of the layer of molding compound and a plurality of sides of the microelectronics package formed by the first cut, and that contacts the plurality of ground leads at the corresponding one or more contact surfaces, the shielding enclosure being comprised of an electromagnetic shielding material.

Each of the plurality of signal leads may include a signal pad, and each of the plurality of ground leads may include a ground pad, each of the corresponding signal pads and each of the corresponding ground pads being exposed through a bottom of the microelectronics package. The plurality of signal leads and the plurality of ground leads may be disposed in a first plane. Stamping the microelectronics package may include forming, in the stamped portion of each of the plurality of ground leads, a bump having a top surface disposed in a second plane that is elevated within the microelectronics package relative to the first plane, the stamped portion of each of the plurality of ground leads being integral with the ground pad of the corresponding ground lead. Making the first cut may include making the first cut to a depth in the microelectronics package that extends through the corresponding top surface of the bump of each of the plurality of ground leads, and that does not extend into contact with any of the plurality of signal leads.

The leadframe may include: a ground flag portion that supports a microelectronics die; and, a plurality of corner bars each extending from a corresponding one of a plurality of corners of the microelectronics package into contact with the ground flag portion. The microelectronics package may further include a plurality of conductive connecting portions each connected between the ground flag portion and a corresponding ground lead of the plurality of ground leads. The stamping may further produce in each of the corner bars a corresponding stamped portion aligned with the corresponding stamped portion of each of the plurality of ground leads, the first cut extending into the corresponding stamped portion of each of the plurality of corner bars to expose corresponding one or more contact surfaces of each of the plurality of corner bars, and the shielding enclosure further contacting each of the plurality of corner bars at the corresponding one or more contact surfaces.

Forming the shielding enclosure may include the steps of: forming a top plate of the shielding enclosure on the top of the microelectronics package; and, forming a plurality of side plates of the shielding enclosure each on a corresponding side of the of the plurality of sides, the plurality of side plates each being integral with the top plate and with adjacent side plates and each contacting a first of the corresponding one or more contact surfaces of each of the plurality of ground leads. Forming the shielding enclosure may further include forming a connecting portion of the shielding enclosure that is integral with each of the plurality of side plates, contacts a second of the corresponding one or more contact surfaces of each of the plurality of ground leads, and extends around the perimeter. Forming the shielding enclosure may include depositing the electromagnetic shielding material onto the microelectronics package with a metal plating process.

Providing the microelectronics package may include providing a microelectronics package strip including the microelectronics package, the microelectronics package being attached, along a first edge of the microelectronics package, to an adjacent microelectronics package by a conductive connection bar attached to a first set of the plurality of ground leads and a second set of the plurality of signal leads, the first set including each of the plurality of ground leads disposed on the first edge and the second set including each of the plurality of signal leads disposed on the first edge. Making the first cut may include forming a cavity in the microelectronics package that extends through a top surface of the corresponding stamped portion of each of the plurality of ground leads in the first set, and that does not extend into contact with any of the plurality of signal leads in the second set. Forming the shielding enclosure may include depositing the electromagnetic shielding material onto a side and a bottom of the cavity. The method may further include making a second cut through the cavity to sever each of the plurality of ground leads in the first set and each of the plurality of signal leads in the second set from the connection bar. Making the second cut may include making the second cut vertically through the strip to define the perimeter of the microelectronics package, the microelectronics package including edges at the perimeter that include a corresponding exposed face of each of the plurality of ground leads and each of the plurality of signal leads.

In another aspect, the present disclosure provides an electromagnetically shielded microelectronic semiconductor device including: a microelectronics package including a leadframe providing a ground plane for the microelectronics package, a plurality of ground leads in electrical communication with the leadframe and extending to a perimeter of the microelectronics package, a plurality of signal leads extending to the perimeter of the microelectronics package, one or more microelectronic components each affixed to one or both of the leadframe and one or more of the plurality of signal leads, and a layer of molding compound disposed over the leadframe, the plurality of ground leads, the plurality of signal leads, and the one or more microelectronic components, a top surface of the layer defining a top of the microelectronics package; and, a shielding enclosure that completely covers the top of the microelectronics package and a plurality of sides of the microelectronics package and that contacts the plurality of ground leads and does not contact the plurality of signal leads, the shielding enclosure composed of an electromagnetic shielding material and cooperating with the plurality of ground leads to provide electromagnetic shielding to the one or more microelectronic components.

Each of the plurality of ground leads may include a stamped portion that is elevated relative to the plurality of signal leads and extends inward from the perimeter, the shielding enclosure contacting the corresponding stamped portion of each of the plurality of ground leads. The corresponding stamped portion of each of the plurality of ground leads may include a notch including a horizontal contact surface extending inward from the perimeter and a vertical contact surface extending from a top surface of the corresponding stamped portion downward to connect with the horizontal contact surface, the shielding enclosure contacting the horizontal contact surface and the vertical contact surface. The shielding enclosure may include: a top portion disposed on the top of the microelectronics package; a connecting portion disposed on a contact surface of the corresponding stamped portion of each of the plurality of ground leads; and, a plurality of side portions each disposed on a corresponding side of the plurality of sides and each attached to or integral with the top portion, the connecting portion, and adjacent side portions.

The leadframe may include a ground flag portion that supports a die for the microelectronic components, the microelectronics package further including one or more conductive connecting portions each connecting a corresponding one of the plurality of ground leads to the ground flag portion. The leadframe may further include a plurality of corner bars each extending from a corresponding one of a plurality of corners of the microelectronics package into contact with the ground flag portion; each of the plurality of ground leads and each of the plurality of corner bars may include a stamped portion that is elevated relative to the plurality of signal leads and extends inward from the perimeter, the shielding enclosure contacting the corresponding stamped portion of each of the plurality of ground leads and each of the plurality of corner bars.

In yet another aspect, the present disclosure provides a method of manufacturing a packaged semiconductor device, the method including providing a microelectronics package that includes a leadframe providing a ground plane of the microelectronics package, and a plurality of ground leads defining a plurality of ground pads and a plurality of signal leads defining a plurality of signal pads, the ground pads and the signal pads exposed through the bottom of the microelectronics package, the ground leads in electrical communication with the leadframe. The method further includes the steps of: forming in each of the plurality of ground leads a bump that is elevated relative to the plurality of signal leads and is disposed between the corresponding ground pad of the ground lead and a perimeter of the microelectronics package; affixing one or more microelectronic components each to one or both of the leadframe and one or more of the plurality of signal leads; disposing a layer of molding compound over the leadframe, the plurality of ground leads, the plurality of signal leads, and the one or more microelectronic components; exposing one or more contact surfaces each on a corresponding bump of one of the plurality of ground leads; and, forming a shielding enclosure over the microelectronics package and in contact with the plurality of ground leads at the corresponding one or more contact surfaces, the shielding enclosure composed of an electromagnetic shielding material.

Forming the bump in each of the plurality of ground leads may include stamping the microelectronics package using a stamp that mechanically contacts each of the plurality of ground leads and does not mechanically contact any of the plurality of signal leads. Exposing the one or more contact surfaces may include making a first cut from a top of the microelectronics package along each of a plurality of edges of the microelectronics package, the first cut extending entirely through the molding compound over the corresponding bump of each of the plurality of ground leads and not entirely through the molding compound over each of the plurality of signal leads. Forming the shielding enclosure may include the steps of: forming a top portion of the shielding enclosure on a top surface of the layer of molding compound; forming a connecting portion of the shielding enclosure on a first of the one or more contact surfaces of the corresponding bump of each of the plurality of ground leads, the connecting portion extending around the microelectronics package; and, forming a plurality of side portions of the shielding enclosure, each of the side portions extending vertically between the top portion and the connecting portion and being attached to or integral with the top portion, the connecting portion, and each adjacent side portion of the plurality of side portions. The leadframe may include a ground flag portion supporting a die for the one or more microelectronic components; the method may further include electrically connecting one or more of the plurality of ground leads to the ground flag portion.

Although the invention(s) is/are described herein with reference to specific embodiments, various modifications and changes can be made without departing from the scope of the present invention(s), as set forth in the claims below. Accordingly, the specification and figures are to be regarded in an illustrative rather than a restrictive sense, and all such modifications are intended to be included within the scope of the present invention(s). Any benefits, advantages, or solutions to problems that are described herein with regard to specific embodiments are not intended to be construed as a critical, required, or essential feature or element of any or all the claims.

Unless stated otherwise, terms such as "first" and "second" are used to arbitrarily distinguish between the elements such terms describe. Thus, these terms are not necessarily intended to indicate temporal or other prioritization of such elements. Similarly, the description may refer to a "top" or "bottom" of a device or element without the intent of limiting the spatial orientation; accordingly, embodiments where the orientation is reversed are contemplated. It should be understood that such terms are utilized to provide a clear description of an implementation of the invention.

The term "coupled" is defined as connected, although not necessarily directly, and not necessarily mechanically. The terms "a" and "an" are defined as one or more unless stated otherwise. The terms "comprise" and any form of comprise, such as "comprises" and "comprising"), "have" (and any form of have, such as "has" and "having"), "include" (and any form of include, such as "includes" and "including") and "contain" (and any form of contain, such as "contains" and "containing") are open-ended linking verbs. As a result, a system, device, or apparatus that "comprises," "has," "includes" or "contains" one or more elements possesses those one or more elements but is not limited to possessing only those one or more elements. Similarly, a method or process that "comprises," "has," "includes" or "contains" one or more operations possesses those one or more operations but is not limited to possessing only those one or more operations.

## Claims

1. A method of manufacturing a semiconductor device, the method comprising:
providing a microelectronics package comprising:
a leadframe providing a ground plane for the microelectronics package;
a plurality of ground leads in electrical communication with the leadframe, the plurality of ground leads extending to a perimeter of the microelectronics package; and
a plurality of signal leads extending to the perimeter of the microelectronics package;
stamping the microelectronics package to produce in each of the plurality of ground leads a stamped portion that is elevated relative to the plurality of signal leads;
affixing one or more microelectronic components to one or both of the leadframe and one or more of the plurality of signal leads;
disposing a layer of molding compound over the leadframe, the plurality of ground leads, the plurality of signal leads, and the one or more microelectronic components, the layer having a top surface extending over the microelectronics package;
making a first cut extending from a top of the microelectronics package into the stamped portion of each of the plurality of ground leads to expose corresponding one or more contact surfaces of each of the plurality of ground leads; and
forming a shielding enclosure that completely covers the top surface of the layer of molding compound and a plurality of sides of the microelectronics package formed by the first cut, and that contacts the plurality of ground leads at the corresponding one or more contact surfaces, the shielding enclosure comprising an electromagnetic shielding material.

2. The method of claim 1, wherein:
each of the plurality of signal leads comprises a signal pad and each of the plurality of ground leads comprises a ground pad, each of the corresponding signal pads and each of the corresponding ground pads being exposed through a bottom of the microelectronics package;
the plurality of signal leads and the plurality of ground leads are disposed in a first plane;
stamping the microelectronics package comprises forming, in the stamped portion of each of the plurality of ground leads, a bump having a top surface disposed in a second plane that is elevated within the microelectronics package relative to the first plane, the stamped portion of each of the plurality of ground leads being integral with the ground pad of the corresponding ground lead; and
making the first cut comprises making the first cut to a depth in the microelectronics package that extends through the corresponding top surface of the bump of each of the plurality of ground leads, and that does not extend into contact with any of the plurality of signal leads.

3. The method of claim 1 or 2, wherein:
the leadframe comprises a ground flag portion that supports a microelectronics die, and a plurality of corner bars each extending from a corresponding one of a plurality of corners of the microelectronics package into contact with the ground flag portion;
the microelectronics package further comprises a plurality of conductive connecting portions each connected between the ground flag portion and a corresponding ground lead of the plurality of ground leads; and
the stamping further produces in each of the corner bars a corresponding stamped portion aligned with the corresponding stamped portion of each of the plurality of ground leads, the first cut extending into the corresponding stamped portion of each of the plurality of corner bars to expose corresponding one or more contact surfaces of each of the plurality of corner bars, and the shielding enclosure further contacting each of the plurality of corner bars at the corresponding one or more contact surfaces.

4. The method of any preceding claim, wherein forming the shielding enclosure comprises:
forming a top plate of the shielding enclosure on the top of the microelectronics package; and
forming a plurality of side plates of the shielding enclosure each on a corresponding side of the of the plurality of sides, the plurality of side plates each being integral with the top plate and with adjacent side plates and each contacting a first of the corresponding one or more contact surfaces of each of the plurality of ground leads.

5. The method of claim 4, wherein forming the shielding enclosure further comprises forming a connecting portion of the shielding enclosure that is integral with each of the plurality of side plates, contacts a second of the corresponding one or more contact surfaces of each of the plurality of ground leads, and extends around the perimeter.

6. The method of any preceding claim, wherein forming the shielding enclosure comprises depositing the electromagnetic shielding material onto the microelectronics package with a metal plating process.

7. The method of any preceding claim , wherein:
providing the microelectronics package comprises providing a microelectronics package strip including the microelectronics package, the microelectronics package being attached, along a first edge of the microelectronics package, to an adjacent microelectronics package by a conductive connection bar attached to a first set of the plurality of ground leads and a second set of the plurality of signal leads, the first set comprising each of the plurality of ground leads disposed on the first edge and the second set comprising each of the plurality of signal leads disposed on the first edge;
making the first cut comprises forming a cavity in the microelectronics package that extends through a top surface of the corresponding stamped portion of each of the plurality of ground leads in the first set, and that does not extend into contact with any of the plurality of signal leads in the second set; and
forming the shielding enclosure comprises depositing the electromagnetic shielding material onto a side and a bottom of the cavity;
the method further comprising making a second cut through the cavity to sever each of the plurality of ground leads in the first set and each of the plurality of signal leads in the second set from the connection bar.

8. The method of claim 7, wherein making the second cut comprises making the second cut vertically through the strip to define the perimeter of the microelectronics package, the microelectronics package comprises edges at the perimeter that include a corresponding exposed face of each of the plurality of ground leads and each of the plurality of signal leads.

9. An electromagnetically shielded microelectronic semiconductor device comprising:
a microelectronics package comprising:
a leadframe providing a ground plane for the microelectronics package;
a plurality of ground leads in electrical communication with the leadframe, the plurality of ground leads extending to a perimeter of the microelectronics package;
a plurality of signal leads extending to the perimeter of the microelectronics package;
one or more microelectronic components each affixed to one or both of the leadframe and one or more of the plurality of signal leads; and
a layer of molding compound disposed over the leadframe, the plurality of ground leads, the plurality of signal leads, and the one or more microelectronic components, a top surface of the layer defining a top of the microelectronics package; and
a shielding enclosure that completely covers the top of the microelectronics package and a plurality of sides of the microelectronics package and that contacts the plurality of ground leads and does not contact the plurality of signal leads, the shielding enclosure comprising an electromagnetic shielding material and cooperating with the plurality of ground leads to provide electromagnetic shielding to the one or more microelectronic components.

10. The semiconductor device of claim 9, wherein each of the plurality of ground leads comprises a stamped portion that is elevated relative to the plurality of signal leads and extends inward from the perimeter, the shielding enclosure contacting the corresponding stamped portion of each of the plurality of ground leads.

11. The semiconductor device of claim 10, wherein the corresponding stamped portion of each of the plurality of ground leads comprises a notch including a horizontal contact surface extending inward from the perimeter and a vertical contact surface extending from a top surface of the corresponding stamped portion downward to connect with the horizontal contact surface, the shielding enclosure contacting the horizontal contact surface and the vertical contact surface.

12. The semiconductor device of claim 10 or 11, wherein the shielding enclosure comprises:
a top portion disposed on the top of the microelectronics package;
a connecting portion disposed on a contact surface of the corresponding stamped portion of each of the plurality of ground leads; and
a plurality of side portions each disposed on a corresponding side of the plurality of sides and each attached to or integral with the top portion, the connecting portion, and adjacent side portions.

13. The semiconductor device any of claim 9 to claim 12, wherein the leadframe comprises a ground flag portion that supports a die for the microelectronic components, the microelectronics package further comprising one or more conductive connecting portions each connecting a corresponding one of the plurality of ground leads to the ground flag portion.

14. The semiconductor device of claim 13, wherein:
the leadframe further comprises a plurality of corner bars each extending from a corresponding one of a plurality of corners of the microelectronics package into contact with the ground flag portion; and
each of the plurality of ground leads and each of the plurality of corner bars comprises a stamped portion that is elevated relative to the plurality of signal leads and extends inward from the perimeter, the shielding enclosure contacting the corresponding stamped portion of each of the plurality of ground leads and each of the plurality of corner bars.
